# EUROPÄISCHE PATENTSCHRIFT

(11) **EP 2 224 595 B1**
(45) Veröffentlichungstag und Bekanntmachung des Hinweises auf die Patenterteilung: **17.04.2013**
(21) Anmeldenummer: 10001353.1
(22) Anmeldetag: 10.02.2010
(51) Int. Cl.: H03K 17/96

(54) **Steuervorrichtung**
Control device
Dispositif de commande

(30) Priorität: 26.02.2009 DE 102009010409
(43) Veröffentlichungstag der Anmeldung: 01.09.2010
(73) Patentinhaber: Diehl AKO Stiftung & Co. KG, 88239 Wangen im Allgäu (DE)
(72) Erfinder: Heimann, Uwe, 88239 Wangen (DE); Prinz, Michael, 88299 Leutkirch (DE); Siebachmeyer, Fritz, 88099 Neukirch (DE)
(74) Vertreter: Diehl Patentabteilung

(56) Entgegenhaltungen:
- EP-A1- 1 460 661
- EP-A1- 1 868 276
- EP-A1- 1 978 618
- DE-A1- 2 824 646

## Beschreibung

Die vorliegende Erfindung betrifft eine Steuervorrichtung für elektronische Haushaltsgeräte.

Bei elektronischen Geräten ohne Netzschalter wird die Steuerschaltung zum Ansteuern des Geräts oder zumindest ein Teil davon bei Nichtgebrauch des Geräts üblicherweise im Stand by - Zustand gehalten. Auf diese Weise wird sichergestellt, dass mittels Betätigung eines entsprechenden elektrischen Schaltelements diese Steuerschaltung wieder aktiviert wird und das Gerät in seinen Betriebszustand übergeht.

Ein Vorteil dieses Konzepts ist es, dass die Steuerschaltung über ein leistungsschwaches und damit kostengünstiges elektrisches Schaltelement in Betrieb genommen werden kann. Nachteilig an dieser Lösung ist jedoch, dass die Steuervorrichtung ständig mit dem Versorgungsnetz verbunden ist und deshalb auch ständig elektrische Energie in Form des so genannten Ruhestroms aus dem Versorgungsnetz zieht.

Aus den Offenbarungen der EP 1 978 618 A1, der EP 1 460 661 A1 und der EP 1 868 276 A1 ist jeweils eine Lösung bekannt, bei der durch Betätigung eines Schalters eine Steuerschaltung über ein Netzteil bestromt wird, wobei die Steuerschaltung bei einer kurzzeitigen Aktivierung des Netzteils durch Betätigung des Schalters einen weiteren Schalter schließt., um das Netzteil dauerhaft zu aktivieren.

Die DE 28 24 646 A1 beschreibt eine Schaltung zur Schnellbremsung eines elektrischen Antriebsmotors, bei welcher durch einen Einschalttaster ein Schütz aktiviert wird, wodurch ein Stromfluss durch den Motor bewirkt wird. Nach dem Erreichen einer Endstellung des Trennschalters wird der Motor wieder vom Netz getrennt und eine generatorisch selbst erregte Bremsung des Motors bewirkt.

Der vorliegenden Erfindung liegt die Aufgabe zugrunde, eine verbesserte Steuervorrichtung ohne Netzschalter, aber mit vermindertem Energieverbrauch zu schaffen.

Diese Aufgabe wird gelöst durch eine Steuervorrichtung mit den Merkmalen des Anspruchs 1. Vorteilhafte Ausgestaltungen und Weiterbildungen der Erfindung sind Gegenstand der abhängigen Ansprüche.

Die erfindungsgemäße Steuervorrichtung weist eine Steuerschaltung, welche bei ausgeschalteter Steuervorrichtung durch einen offenen dritten Schalter von einem Versorgungsnetz getrennt ist, und ein Betätigungselement zum Einschalten der Steuervorrichtung, bei dessen Betätigung die Steuerschaltung mit dem Versorgungsnetz verbunden wird, auf. Das Betätigungselement wiederum weist einen passiven elektrischen Impulsgeber auf, der bei einer Betätigung des Betätigungselements einen elektrischen Impuls erzeugt, der eine Verbindung der Steuerschaltung mit dem Versorgungsnetz bewirkt. Das Betätigungselement fungiert als Hauptschalter.

Durch die Verwendung eines Betätigungselements mit einem passiven elektrischen Impulsgeber kann die gesamte Steuervorrichtung im ausgeschalteten Zustand von dem Versorgungsnetz getrennt werden. Mit anderen Worten ist kein Standby - Betrieb der Steuerschaltung notwendig, der auch bei ausgeschalteter Steuervorrichtung Energie verbrauchen würde.

Unter einem "passiven elektrischen Impulsgeber" wird ein Element verstanden, das bei seiner Betätigung ohne Zufuhr elektrischer Energie einen elektrischen Impuls erzeugt. Der passive elektrische Impulsgeber muss also nicht mit dem Versorgungsnetz verbunden sein und verbraucht daher auch keinen Ruhestrom. Die Erzeugung des elektrischen Impulses wird durch ein mechanisch (z.B. durch Berührung, Druck, etc.) zu bedienendes Element ausgelöst, das zum Beispiel als berührungsempfindlicher Schalter oder als Drucktaste ausgeführt sein kann.

Der passive elektrische Impulsgeber des Betätigungselements kann beispielsweise ein piezoelektrisches Element oder ein induktives Element enthalten bzw. durch ein derartiges Element gebildet sein.

In einer Ausgestaltung der Erfindung kann ferner eine Umformschaltung zum Umformen des von dem passiven elektrischen Impulsgeber erzeugten Impulses in eine geeignete Form vorgesehen sein, sodass der erzeugte und ggf. umgeformte elektrische Impuls die gewünschten Steuervorgänge auslöst.

Erfindungsgemäß ist zwischen dem Betätigungselement und der Steuerschaltung eine Hilfsschaltung angeordnet. Diese Hilfsschaltung ist bei ausgeschalteter Steuervorrichtung von dem Versorgungsnetz getrennt. Durch einen von dem Impulsgeber des Betätigungselements erzeugten und ggf. durch die Umformschaltung umgeformten Impuls wird die Hilfsschaltung dauerhaft mit dem Versorgungsnetz verbunden und verbindet in diesem mit dem Versorgungsnetz verbundenen Zustand auch die Steuerschaltung mit dem Versorgungsnetz. Die Hilfsschaltung verfügt über eine so genannte Selbsthaltefunktion, d.h. ein kurzzeitiger elektrischer Impuls von dem Impulsgeber genügt, um die Hilfsschaltung dauerhaft in einen anderen Betriebszustand, hier eine Verbindung mit dem Versorgungsnetz, zu versetzen.

Zur Realisierung dieser Selbsthaltefunktion ist die Hilfsschaltung über einen ersten Schalter und einen zweiten Schalter mit dem Versorgungsnetz verbindbar. Bei ausgeschalteter Steuervorrichtung sind beide Schalter offen, d.h. ist die Hilfsschaltung von dem Versorgungsnetz getrennt. Ein von dem passiven elektrischen Impulsgeber des Betätigungselements erzeugter Impuls schließt dann den ersten Schalter kurzzeitig, wobei die Hilfsschaltung bei geschlossenem erstem Schalter den zweiten Schalter betätigt, d.h. zum Einschalten der Steuervorrichtung schließt.

So kann die Hilfsschaltung bei geschlossenem zweitem Schalter die Steuerschaltung über einen dritten Schalter mit dem Versorgungsnetz verbinden.

In einer weiteren Ausgestaltung der Erfindung kann das Betätigungselement vorzugsweise auch dem Ausschalten der Steuervorrichtung dienen. Eine Betätigung des Betätigungselements zum Ausschalten erzeugt dann einen elektrischen Impuls, der eine Trennung der Hilfsschaltung und damit auch der Steuerschaltung von dem Versorgungsnetz bewirkt.

Die oben beschriebene Steuervorrichtung der Erfindung wird in vorteilhafter Weise für elektronische Haushaltsgeräte wie zum Beispiel Herde, Kochfelder, Mikrowellenöfen, Waschmaschinen, Trockner, Spülmaschinen, TV-Geräte, Hifi-Geräte, usw. eingestzt.

Obige sowie weitere Merkmale, Vorteile und Anwendungsmöglichkeiten der Erfindung werden aus der nachfolgenden Beschreibung eines Ausführungsbeispiels unter Bezug auf die beiliegende Zeichnung besser verständlich. Darin zeigt die einzige Figur ein stark vereinfachtes Blockschaltbild einer Steuervorrichtung gemäß der vorliegenden Erfindung.

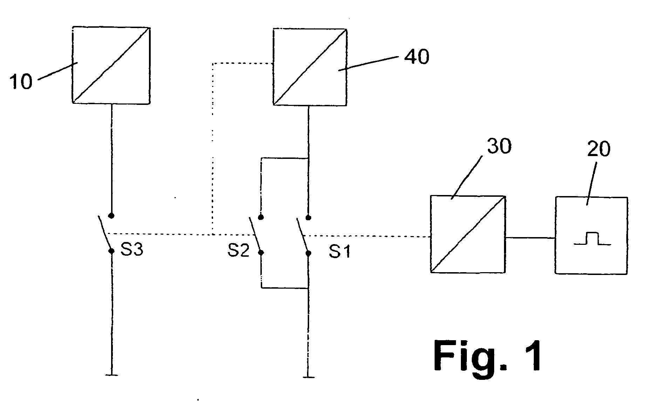

Die in Figur 1 veranschaulichte Steuervorrichtung sieht vor, mit Hilfe eines kurzzeitigen elektrischen Impulses, der bei Betätigung eines passiven, d.h. nicht mit einem Versorgungsnetz verbundenen Bauelements erzeugt wird, die Steuervorrichtung und damit das gesamte Gerät zu aktivieren.

Die Steuervorrichtung enthält eine Steuerschaltung 10 zum Ansteuern des jeweiligen elektronischen Geräts sowie ein Betätigungselement 20 zum Ein- und Ausschalten dieser Steuervorrichtung und damit des gesamten Geräts. Ist die Bedienblende mit Touch Sensoren ausgestattet, so ist vorzugsweise auch das Betätigungselement 20 als ein berührungsempfindlicher Schalter ausgeführt, um ein homogenes Blendendesign zu erzielen. Grundsätzlich kann das Betätigungselement aber ebenso als Drucktaste oder dergleichen ausgebildet werden.

Das Betätigungselement 20 weist einen passiven elektrischen Impulsgeber auf, der bei Betätigung des Betätigungselements 20 einen elektrischen Impuls erzeugt. Als passives Bauelement ist dieser Impulsgeber nicht mit dem Versorgungsnetz verbunden. Dieser passive elektrische Impulsgeber kann zum Beispiel ein piezoelektrisches Element oder ein induktives Element enthalten.

Der von dem Impulsgeber des Betätigungselements 20 erzeugte Impuls wird vorzugsweise in einer Umformschaltung 30 in geeigneter Weise umgeformt. Zu den Umformungsmaßnahmen gehören insbesondere auch eine Veränderung der Form des elektrischen Impulses und eine Veränderung der Impulsdauer.

Zwischen das Betätigungselement 20 und die Umformschaltung 30 einerseits und die Steuerschaltung 10 andererseits ist ferner eine Hilfsschaltung 40 mit einer Selbsthaltefunktion gesetzt. Diese Hilfsschaltung 40 ist über einen ersten Schalter S1 und einen zweiten Schalter S2 mit dem Versorgungsnetz verbindbar und steuert einerseits den zweiten Schalter S2 und andererseits auch einen dritten Schalter S3, der die Steuerschaltung 10 mit dem Versorgungsnetz verbindet bzw. von ihm trennt.

Der elektrische Impuls des Betätigungselements 20 bzw. der Umformschaltung 30 steuert die Funktion des ersten Schalters S1. D.h. der Impulsgeber des Betätigungselements 20 sendet bei mechanischer Betätigung des Betätigungselements 20 einen elektrischen Impuls an die Umformschaltung 30, die den Impuls so umwandelt, dass dieser ein kurzzeitiges Schließen des ersten Schalters S1 bewirkt. Über den so geschlossenen ersten Schalter S1 wird die Hilfsschaltung 40 mit dem Versorgungsnetz verbunden und damit aktiviert. Die aktivierte Hilfsschaltung 40 schließt dann den zweiten Schalter S2 und erzeugt so eine Selbsthaltung. D.h. die Hilfsschaltung 40 bleibt über den geschlossenen zweiten Schalter S2 mit dem Versorgungsnetz verbunden, auch wenn der erste Schalter S1 nach kurzer Zeit wieder öffnet. Die aktivierte Hilfsschaltung 40 schließt weiter den dritten Schalter S3 und verbindet damit auch die Steuerschaltung 10 und damit das gesamte elektronische Gerät mit dem Versorgungsnetz.

Das Betätigungselement 20 kann auch zum Ausschalten der Steuervorrichtung bzw. des Geräts benutzt werden. Ausgehend von dem eingeschalteten Betriebszustand wird der erste Schalter S1 durch einen von dem Impulsgeber des Betätigungselements 20 erzeugten Impuls geschlossen. Dieses Schließen des ersten Schalters S1 wird von der Hilfsschaltung 40 erfasst, die daraufhin wieder den zweiten Schalter S2 betätigt, also in diesem Fall öffnet, und damit die Hilfsschaltung 40 von dem Versorgungsnetz trennt und so deaktiviert. Die Deaktivierung der Hilfsschaltung 40 bewirkt gleichzeitig ein Öffnen des dritten Schalters S3, sodass die Steuerschaltung 10 und damit das Gerät von dem Versorgungsnetz getrennt werden. Alternativ kann zum Ausschalten der Steuervorrichtung auch ein zusätzliches Schaltelement, welches nicht notwendigerweise als passives Bauelement ausgebildet sein muss, vorgesehen sein.

In diesem ausgeschalteten Zustand ist dann die gesamte Steuervorrichtung (einschließlich des Hauptschalters 20 und seines Impulsgebers) von dem Versorgungsnetz getrennt und verbraucht - im Gegensatz zu dem Standby - Betriebszustand herkömmlicher Steuervorrichtungen - keine elektrische Energie.

### BEZUGSZIFFERNLISTE

| | |
|---|---|
| 10 | Steuerschaltung |
| 20 | Hauptschalter |
| 30 | Umformschaltung |
| 40 | Hilfsschaltung |

## Patentansprüche

1. Steuervorrichtung, mit
einer Steuerschaltung (10) zum Ansteuern eines elektronischen Haushaltsgerätes, die bei ausgeschalteter Steuervorrichtung durch einen offenen dritten Schalter (S3) von einem Versorgungsnetz getrennt ist; und einem Betätigungselement (20) zum Einschalten der Steuervorrichtung, bei dessen Betätigung die Steuerschaltung (10) mit dem Versorgungsnetz verbunden wird, wobei das Betätigungselement (20) einen passiven elektrischen Impulsgeber aufweist, der bei einer Betätigung des Betätigungselements (20) einen elektrischen Impuls erzeugt, der eine Verbindung der Steuerschaltung (10) mit dem Versorgungsnetz bewirkt,
**dadurch gekennzeichnet, dass**
zwischen dem Betätigungselement (20) und der Steuerschaltung (10) eine Hilfsschaltung (40) angeordnet ist, welche
über eine Parallelschaltung aus einem ersten Schalter (S1) und einem zweiten Schalter (S2) mit dem Versorgungsnetz verbindbar ist,
den zweiten Schalter (S2) und den dritten Schalter (S3) steuert,
bei ausgeschalteter Steuervorrichtung durch den offenen ersten Schalter (S1) und den offenen zweiten Schalter (S2) von dem Versorgungsnetz getrennt ist,
durch einen von dem Impulsgeber des Betätigungselements (20) erzeugten Impuls dauerhaft mit dem Versorgungsnetz verbunden wird, indem der Impuls den ersten Schalter (S1) kurzzeitig schließt, sodass die Hilfsschaltung (40) mit dem Versorgungsnetz verbunden und damit aktiviert wird,
im aktivierten Zustand den zweiten Schalter (S2) schließt und damit eine Selbsthaltung erzeugt, und
in einem mit dem Versorgungsnetz verbundenen und damit aktivierten Zustand die Steuerschaltung (10) mit dem Versorgungsnetz verbindet, indem sie den dritten Schalter (S3) schließt.

2. Steuervorrichtung nach Anspruch 1,
**dadurch gekennzeichnet,**
**dass** der Impulsgeber des Betätigungselements (20) ein piezoelektrisches Element enthält.

3. Steuervorrichtung nach Anspruch 1,
**dadurch gekennzeichnet,**
**dass** der Impulsgeber des Betätigungselements (20) ein induktives Element enthält.

4. Steuervorrichtung nach einem der vorherigen Ansprüche,
**dadurch gekennzeichnet,**
**dass** eine Umformschaltung (30) zum Umformen des von dem Impulsgeber erzeugten Impulses in eine geeignete Form vorgesehen ist.

## Claims

1. Control apparatus having
a control circuit (10) for actuating an electronic domestic appliance, which control circuit is disconnected from a supply system by an open third switch (S3) when the control apparatus is switched off; and
an operating element (20) for switching on the control apparatus, the control circuit (10) being connected to the supply system when the said operating element is operated, wherein the operating element (20) has a passive electrical pulse transmitter which, when the operating element (20) is operated, generates an electrical pulse which connects the control circuit (10) to the supply system,
**characterized in that**
an auxiliary circuit (40) is arranged between the operating element (20) and the control circuit (10), which auxiliary circuit
can be connected to the supply system via a parallel circuit comprising a first switch (S1) and a second switch (S2),
controls the second switch (S2) and the third switch (S3),
is disconnected from the supply system by the open first switch (S1) and the open second switch (S2) when the control apparatus is switched off,
is permanently connected to the supply system by a pulse, which is generated by the pulse transmitter of the operating element (20), by the pulse short-circuiting the first switch (S1), with the result that the auxiliary circuit (40) is connected to the supply system and therefore activated,
closes the second switch (S2) in the activated state and therefore generates a self-latching, and
in a state in which it is connected to the supply system and is therefore activated, connects the control circuit (10) to the supply system by closing the third switch (S3).

2. Control apparatus according to Claim 1,
**characterized**
**in that** the pulse transmitter of the operating element (20) contains a piezoelectric element.

3. Control apparatus according to Claim 1,
**characterized**
**in that** the pulse transmitter of the operating element (20) contains an inductive element.

4. Control apparatus according to one of the preceding claims,
**characterized**
**in that** a converting circuit (30) for converting the pulse which is generated by the pulse transmitter into a suitable form is provided.

## Revendications

1. Dispositif de commande, comprenant :
un circuit de commande (10) pour commander un appareil électroménager, qui est séparé d'un réseau d'alimentation par un troisième commutateur (S3) ouvert lorsque le dispositif de commande est déconnecté ; et
un élément d'actionnement (20) pour brancher le dispositif de commande, lors de l'actionnement duquel le circuit de commande (10) est connecté au réseau d'alimentation, l'élément d'actionnement (20) présentant un générateur d'impulsion électrique passif qui, lors d'un actionnement de l'élément d'actionnement (20), génère une impulsion électrique qui provoque une connexion du circuit de commande (10) à un réseau d'alimentation,
**caractérisé en ce**
**qu'**entre l'élément d'actionnement (20) et le circuit de commande (10) est disposé un circuit auxiliaire (40) qui
peut être connecté par le biais d'un circuit en parallèle constitué d'un premier commutateur (S1) et d'un deuxième commutateur (S2) au réseau d'alimentation,
commande le deuxième commutateur (S2) et le troisième commutateur (S3),
lorsque le dispositif de commande est déconnecté, est séparé par le premier commutateur ouvert (S1) et le deuxième commutateur ouvert (S2) du réseau d'alimentation,
est connecté au réseau d'alimentation de manière permanente par une impulsion générée par le générateur d'impulsion de l'élément d'actionnement (20), par le fait que l'impulsion ferme brièvement le premier commutateur (S1), de telle sorte que le circuit auxiliaire (40) soit connecté au réseau d'alimentation et donc activé,
dans l'état activé, ferme le deuxième commutateur (S2) et donc génère une auto-rétention, et
dans un état connecté au réseau d'alimentation et donc activé, relie le circuit de commande (10) au réseau d'alimentation, en fermant le troisième commutateur (S3).

2. Dispositif de commande selon la revendication 1,
**caractérisé en ce que**
le générateur d'impulsion de l'élément d'actionnement (20) contient un élément piézoélectrique.

3. Dispositif de commande selon la revendication 1,
**caractérisé en ce que**
le générateur d'impulsion de l'élément d'actionnement contient un élément inductif.

4. Dispositif de commande selon l'une quelconque des revendications précédentes,
**caractérisé en ce**
**qu'**un circuit de déformation (30) est prévu pour déformer l'impulsion générée par le générateur d'impulsion dans une forme appropriée.
